# EUROPEAN PATENT APPLICATION

(11) **EP 4 344 577 A1**
(43) Date of publication of application: **03.04.2024**
(21) Application number: 22306450.2
(22) Date of filing: 29.09.2022
(51) Int. Cl.: A44C 27/00, C23C 16/00

(54) **COATED SILVER PRODUCTS AND METHODS FOR MAKING THE SAME**

(71) Applicant: Nexdot, 93230 Romainville (FR)
(72) Inventor: DUFOND, Maxime, 93230 Romainville (FR); D'AMICO, Michele, 93230 Romainville (FR); DUBERTRET, Benoit, 93230 Romainville (FR)
(74) Representative: Icosa

(57) **Abstract**

The present invention relates to coatings providing resistance against scratches, abrasion, oxidation and sulfidation, to silver-based substrates. More specifically, it relates to a silver-based substrate (11) covered with a coating (12) comprising a composite layer of black pigments (121) embedded in a nitride continuous matrix (122). It also relates to a coating method according to the invention.

## Description

### FIELD OF INVENTION

The present invention relates to coatings providing resistance against scratches, abrasion, oxidation and sulfidation, to silver-based substrates. The present invention also relates to a coating method for imparting resistance against scratches, abrasion, oxidation and sulfidation, to silver-based substrates.

### BACKGROUND OF INVENTION

In the field of jewelry, it is known to plate metallic jewelry in order to harden, to alter conductivity, to inhibit corrosion, to reduce friction, to improve paint adhesion, to improve solderability, to improve wearability, for radiation shielding, or even for decoration.

Known plating methods rely on the deposition of a thin layer of material on the surface of a substrate by electroplating, physical vapor deposition (PVD) or chemical vapor deposition (CVD).

In the specific case of silver-based jewelry, tarnishing is of huge importance. Indeed, silver is prone to reaction with oxidants and sulfur containing compounds - either air borne as pollutants: hydrogen sulfide or volatile mercaptans emitted from raw foodstuff for instance, or coming from sweat. Such reactions yield dark/black colour which is usually not desired. The whole industry of jewelry has been oriented towards avoiding tarnishing, especially avoiding silver sulfide apparition.

However, dark decoration on silver-based jewelry is sometimes desired, under the condition that this coloration is stable in time. By stable, two conditions may be contemplated independently. First, the colour perceived by the owner of jewels should be the same over time: if tarnishing occurs, it should not affect the perceived colour of the object. Second, the shape of decoration should not change. Indeed, tarnishing - and more generally oxidation/sulfidation - leads to blurred limits. Where a straight frontier was traced between a shiny silver area and a dark decoration, tarnishing leads to bumps or dimples and the straight frontier becomes fuzzy.

There is thus a need for a coating providing to a silver-based substrate a stable dark coloration able to be designed according to a predetermined pattern or to cover uniformly the substrate while ensuring scratch resistance, resistance to corrosion by sweat, sulphureous agents or wet heat, resistance to ultraviolet radiation, and/or resistance to polyservice type wear.

The Applicant has found that this need could be met with a coating comprising a composite layer of black pigments embedded in a nitride and/or oxide continuous matrix, said coating being deposited on a silver-based substrate.

### SUMMARY

This disclosure thus relates to a silver-based substrate with a coating in contact with the substrate, wherein the coating comprises a composite layer of black pigments embedded in a nitride and/or oxide continuous matrix, and wherein the silver-based substrate and the coating at least partially form a jewelry article or a component of a jewelry article.

In an embodiment, black pigments are selected in the group of carbon black, ivory black, vine black, lamp black, graphene, mars black, iron black, manganese dioxide, titanium black, semi-conductive nanoparticles having a band gap of 1.6 eV or less. In particular, the semi-conductive nanoparticles having a band gap of 1.6 eV or less may be metal chalcogenides, where metal is selected from Hg, Pb, Ag, Bi, Cd, Sn, Sb or a mixture thereof and chalcogen is selected from S, Se, Te or a mixture thereof, preferably semi-conductive nanoparticles having a band gap of 1.6 eV or less may be selected from HgS, HgSe, HgTe, HgSeS, HgSeTe, HgₓCd₁₋ₓTe wherein x is a real number strictly comprised between 0 and 1, PbS, PbSe, PbTe, Bi₂S₃, Bi₂Se₃, Bi₂Te₃, SnS, SnS₂, SnTe, SnSe, Sb₂S₃, Sb2Se3, Sb2Te3, Ag2S, Ag2Se, Ag2Te and mixtures thereof.

In an embodiment, the nitride and/or oxide continuous matrix comprises at least one of titanium nitride (TiN), titanium(II) nitride (Ti2N), titanium carbo-nitride (TiCN), titanium-aluminum nitride (TiAIN), titanium-aluminum carbo-nitride (TiAlCN), chromium nitride (CrN), zirconium nitride (ZrN), aluminum nitride (AlN), silicon nitride (SiN), chromium-titanium nitride (CrTiN), aluminum-titanium nitride (AlTiN), aluminum-titanium-chromium nitride (AlTiCrN), tungsten nitride (WN), titanium oxide (TiO₂), carbon-titanium dioxide, titanium-aluminum oxide (Al₂TiO₅), chromium oxide (CrO), zirconium oxide (ZrO₂), aluminum oxide (Al₂O₃), silicon oxide (SiO₂), chromium-titanium oxide (Cr₂TiO₅), aluminum-titanium oxide (Al₂O₅Ti), tungsten oxide (WO₃), aluminum oxynitride (Al_{2/3}OₓN₁₋ₓ), silicon oxynitride (Si_{1/2}OₓN₁₋ₓ), titanium oxynitride (Ti_{1/2}OₓN₁₋ₓ), titanium-aluminum oxinitride (TiAlOₓN₁₋ₓ), aluminum-chromium oxynitride ((Al,Cr)OₓN₁₋ₓ), aluminum-titanium-chromium oxynitride ((Al,Cr)TiOₓN₁₋ₓ), where x is a real number strictly comprised between 0 and 1.

In an embodiment, black pigments are distributed uniformly on the silver-based substrate. Alternatively, black pigments are distributed according to a predetermined pattern on the silver-based substrate.

In an embodiment, the weight fraction of black pigments in the coating is ranging from 1 %wt to 30 %wt.

In an embodiment, the absorbance of the coating is ranging from 0.1 to 2, where black pigments are present.

In an embodiment, the thickness of the coating is ranging from 10 nm to 1000 nm, preferably from 20 nm to 700 nm.

This disclosure also relates to a coating method comprising the steps of
a) depositing black pigments on a silver-based substrate,
b) depositing a nitride and/or oxide layer on the black pigments and silver-based substrate,
wherein the silver-based substrate and the coating at least partially form a jewelry article or a component of a jewelry article.

In an embodiment, black pigments are deposited in step a) uniformly on the silver-based substrate. Alternatively, black pigments are deposited in step a) on the silver-based substrate according to a predetermined pattern, for instance by stamping or with a stencil.

In an embodiment, the nitride and/or oxide layer is deposited by PVD, CVD, PACVD, ALD, IAD, dip coating, spray coating, spin coating.

In an embodiment, the black pigments are selected in the group of carbon black, ivory black, vine black, lamp black, graphene, mars black, iron black, manganese dioxide, titanium black, semi-conductive nanoparticles having a band gap of 1.6 eV or less. In particular, the semi-conductive nanoparticles having a band gap of 1.6 eV or less may be metal chalcogenides, where metal is selected from Hg, Pb, Ag, Bi, Cd, Sn, Sb or a mixture thereof and chalcogen is selected from S, Se, Te or a mixture thereof, preferably semi-conductive nanoparticles having a band gap of 1.6 eV or less may be selected from HgS, HgSe, HgTe, HgSeS, HgSeTe, HgₓCd₁₋ₓTe wherein x is a real number strictly comprised between 0 and 1, PbS, PbSe, PbTe, Bi₂S₃, Bi₂Se₃, Bi₂Te₃, SnS, SnS₂, SnTe, SnSe, Sb₂S₃, Sb2Se3, Sb2Te3, Ag2S, Ag2Se, Ag2Te and mixtures thereof.

In an embodiment, the nitride and/or oxide continuous matrix comprises at least one of titanium nitride (TiN), titanium(II) nitride (Ti2N), titanium carbo-nitride (TiCN), titanium-aluminum nitride (TiAIN), titanium-aluminum carbo-nitride (TiAlCN), chromium nitride (CrN), zirconium nitride (ZrN), aluminum nitride (AlN), silicon nitride (SiN), chromium-titanium nitride (CrTiN), aluminum-titanium nitride (AlTiN), aluminum-titanium-chromium nitride (AlTiCrN), tungsten nitride (WN), titanium oxide (TiO₂), carbon-titanium dioxide, titanium-aluminum oxide (Al₂TiO₅), chromium oxide (CrO), zirconium oxide (ZrO₂), aluminum oxide (Al₂O₃), silicon oxide (SiO₂), chromium-titanium oxide (Cr₂TiO₅), aluminum-titanium oxide (Al₂O₅Ti), tungsten oxide (WO₃), aluminum oxynitride (Al_{2/3}OₓN₁₋ₓ), silicon oxynitride (Si_{1/2}OₓN₁₋ₓ), titanium oxynitride (Ti_{1/2}OₓN₁₋ₓ) titanium-aluminum oxinitride (TiAlOₓN₁₋ₓ), aluminum-chromium oxynitride ((Al,Cr)OₓN₁₋ₓ), aluminum-titanium-chromium oxynitride ((Al,Cr)TiOₓN₁₋ₓ), where x is a real number strictly comprised between 0 and 1

### DEFINITIONS

In the present invention, the following terms have the following meanings:

"**Absorbance**" is the decimal logarithm of the ratio I₀/I, where I₀ is the intensity of light incidents on a sample and I is the intensity of light transmitted through said sample. In this disclosure, absorbance is measured for a coating on a silver-based substrate, whatever the thickness of the coating and assuming that the silver-based substrate behaves like a perfect mirror. Thus, optical path of light from source to measurement device passes through the coating twice. Basic calculation allows to retrieve the absorbance for a single pass through the coating Alternatively, absorbance may be measured by difference between the uncoated silver-based substrate and the coated silver-based substrate, thus taking into account an absorption contribution of the silver-based substrate. Absorbance is measured for wavelengths in visible and infrared light range from 380 nm to 2 µm, or a subrange of visible and infrared light, but comprising the whole visible range from 380 nm to 780 nm.

"**Band gap**" refers to the difference of energy between the top of the valence band and the bottom of the conduction band, *i.e.,* the energy range where no electron states can exist due to the quantization of energy. Optical properties - especially absorption - is determined by the susceptibility of electrons to excitation from the valence band to the conduction band.

"**Jewelry**" refers to personal adornments worn for ornament or utility. Jewelry includes but is in no way limited to rings, ornamental rings, engagement rings, toe rings, watches, watchcases, bracelets, necklaces, chains, pendants, charms, armlets, brocades, pins, clips, hairclips, carved beads, fobs, ornamental piercings, earrings, nose rings, body jewelry, dog tags, amulets, bangle bracelets, cuff bracelets, link bracelets, cuff links, tie clips, tie pins, tie tacks, key chains, money clips, cell phone charms, cutlerys, writing utensils, pens, charms, signet rings, class rings, friendship rings or purity rings.

"N**itride matrix**" refers to a compound comprising at least one transition metal or substance with metallic properties and nitrogen or nitrogen containing chemical compound. In some embodiments, metal nitrides for use in the present disclosure include but are in no way limited to titanium nitride, chromium nitride, zirconium nitride, tungsten nitride, gold nitride, silver nitride, aluminum nitride, vanadium nitride, tantalum nitride, aluminum-titanium-nitride, titanium-aluminum-nitride and titanium-carbon-nitride.

"O**xide matrix**" refers to a compound comprising at least one transition metal or substance with metallic properties and oxygen or oxygen containing chemical compound. In some embodiments, metal oxides for use in the present disclosure include but are in no way limited to titanium oxide, carbon-titanium dioxide, titanium-aluminum oxide, chromium oxide, zirconium oxide, aluminum oxide, silicon oxide, chromium-titanium oxide, aluminum-titanium oxide and tungsten oxide.

"O**xinitride matrix**" refers to a compound comprising at least one transition metal or substance with metallic properties and a mixture of nitrogen or nitrogen containing chemical compound and oxygen or oxygen containing chemical compound. In some embodiments, metal oxinitrides for use in the present disclosure include but are in no way limited to aluminum oxynitride, silicon oxynitride, titanium oxynitride, titanium-aluminum oxinitride, aluminum-chromium oxynitride, aluminum-titanium-chromium oxynitride, where x is a real number strictly comprised between 0 and 1. In this disclosure, "a nitride and oxide" element is equivalent to an "oxinitride" element.

"**Semi-conductive nanoparticles**" refers to particles made of a material having an electronic structure corresponding to semi-conductive materials but having a nanometric size. Due to their specific electronic structure, semi-conductive materials behave as high-pass absorbing materials. Indeed, light having a wavelength more energetic than band gap may be absorbed by the semi-conductive material, yielding an electron/hole pair, an exciton, which later recombines in the material and dissipate heat, or emit light, or both. On the contrary, light having a wavelength less energetic than band gap cannot be absorbed: semi-conductive material is transparent for these wavelengths. Semi-conductive nanoparticles with a band gap of 1.6 eV or less absorb all light with an energy of 1.6 eV or more, *i.e.,* all visible light with wavelength shorter than 780 nm.

"**Silver alloy**" refers to a mixture of silver with at least one other metal selected among tungsten, cobalt, tungsten, titanium, zirconium, tantalum, aluminum, rhodium, gold, platinum, palladium, iridium, iron, stainless steel, nickel, niobium, vanadium, ruthenium, copper, zinc, tin, molybdenum, hafnium or rhenium.

"**Vapor Deposition**" refers to a general process for the deposition of compounds onto a designated substrate. In preferred embodiments, the use of vapor deposition in the context of the present disclosure refers to chemical vapor deposition (CVD) - including thermal atomic layer deposition (thermal ALD) and plasma enhanced atomic layer deposition (plasma ALD) - physical vapor deposition (PVD), plasma enhanced chemical vapor deposition (PECVD), diamond CVD coating, ionized physical vapor deposition (IPVD), sputtering and thermal evaporation.

### DETAILED DESCRIPTION

### Coated silver-based substrate

This invention relates to a silver-based substrate with a coating in contact with the substrate,
wherein the coating comprises a composite layer of black pigments embedded in a nitride or oxide continuous matrix,
wherein the silver-based substrate and the coating at least partially form a jewelry article or a component of a jewelry article.

Advantageously, the coating provides to the silver-based substrate:
- a dark coloration due to the presence of black pigments, said coloration can be designed according to a predetermined pattern or cover uniformly the substrate;
- scratch resistance, resistance to corrosion by sweat, sulphureous agents or wet heat, and/or resistance to polyservice type wear due to the continuous matrix.

In particular, the dark coloration of the silver-based substrate is stable in time.

Silver-based substrate includes substrates comprising pure silver or a silver alloy.

According to one embodiment, silver-based substrate comprises at least one of a silver jewelry article, a silver component of a jewelry article, a decorative silver piece, or silver foil.

In a specific configuration of this embodiment, the jewelry article or component of the jewelry article is a ring, ornamental ring, engagement ring, toe ring, watch, bracelet, necklace, pendant, charm, armlet, brocade, pin, clip, hairclip, fob, ornamental piercing, earring, nose ring, dog tag, amulet, bangle bracelet, cuff bracelet, link bracelet, cuff link, key chain, money clip, cell phone charm, signet ring, class ring, friendship ring or purity ring or a component any of the foregoing.

### Black pigments

Black pigments encompass inorganic compounds showing a significant absorption of light over the whole visible range -defined as the wavelength range from 380 nm to 780 nm - so that the article in which black pigments are dispersed appears black, or at last dark.

According to one embodiment, black pigments are selected in the group of carbon black, ivory black, vine black, lamp black, graphene, mars black, iron black, manganese dioxide, titanium black, semi-conductive nanoparticles having a band gap of 1.6 eV or less, or a mixture thereof. Particularly suitable semi-conductive nanoparticles are metal chalcogenides, where metal is selected from Hg, Pb, Ag, Bi, Cd, Sn, Sb or a mixture thereof and chalcogen is selected from S, Se, Te or a mixture thereof. The following semi-conductive nanoparticles may be used: HgS, HgSe, HgTe, HgSeS, HgSeTe, HgₓCd₁₋ₓTe wherein x is a real number strictly comprised between 0 and 1, PbS, PbSe, PbTe, Bi₂S₃, Bi₂Se₃, Bi₂Te₃, SnS, SnS₂, SnTe, SnSe, Sb₂S₃, Sb₂Se₃, Sb₂Te₃, Ag₂S, Ag₂Se, Ag₂Te.

In a preferred configuration of this embodiment, black pigments are silver sulfide (Ag2S) particles. Such particles are particularly advantageous, because they are exactly the compound obtained by alteration of silver by a sulphureous compound as during natural tarnishing processes. Therefore, unwanted alteration of the silver-based substrate would produce silver sulfide, which has the same colour as the black pigment already present. Tarnishing is thus masked and colour of the silver-based substrate appears stable in time.

According to one embodiment, black pigments have a mean size between 3 nm and 4000 nm. When black pigments are semi-conductive nanoparticles, their size is preferably between 3 nm and 100 nm. Such very small size allows to prepare thin coatings with a thickness below optical length so as to avoid light interferometric effects.

In a preferred configuration, black pigments are silver sulfide (Ag2S) nanoparticles having a mean size ranging from 3 nm to 20 m.

According to one embodiment, black pigments are composite particles. By composite particles, it is meant particles comprising nanoparticles such as, for example Ag₂S nanoparticles, and a second material, said second material being either a binder yielding aggregates, or a matrix either continuous or porous yielding nanoparticles embedded in a matrix. Preferably, the binder/matrix is transparent in the range of wavelengths where nanoparticles absorb light.

In a specific configuration of this embodiment, the matrix of the composite particle is inorganic. Inorganic materials may be selected in the group of metals, halides, chalcogenides, phosphides, sulfides, metalloids, metallic alloys, ceramics such as for example oxides, carbides, nitrides, glasses, enamels, ceramics, stones, precious stones, pigments, cements and/or inorganic polymers. Oxide are particularly suitable for composite particles: they may be selected in the group of SiO₂, Al₂O₃, TiO₂, ZrO₂, ZnO, MgO, SnO₂, Nb₂O₅, CeO₂, BeO, IrO₂, CaO, Sc₂O₃, NiO, Na₂O, BaO, K₂O, PbO, Ag₂O, V₂O₅, TeO₂, MnO, B₂O₃, P₂O₅, P₂O₃, P₄O₇, P₄O₈, P₄O₉, P₂O₆, PO, GeO₂, As₂O₃, Fe₂O₃, Fe₃O₄, Ta₂O₅, Li₂O, SrO, Y₂O₃, HfO₂, WO₂, MoO₂, Cr₂O₃, Tc₂O₇, ReO₂, RuO₂, Co₃O₄, OsO, RhO₂, Rh₂O₃, PtO, PdO, CuO, Cu₂O, CdO, HgO, Tl₂O, Ga₂O₃, In₂O₃, Bi₂O₃, Sb₂O₃, PoO₂, SeO2, Cs₂O, La₂O₃, Pr₆O₁₁, Nd₂O₃, La₂O₃, Sm₂O₃, Eu₂O₃, Tb₄O₇, Dy₂O₃, Ho₂O₃, Er₂O₃, Tm₂O₃, Yb₂O₃, Lu₂O₃, Gd₂O₃, or a mixture thereof. SiO₂ and Al₂O₃, alone or in mixture are especially suitable. They can be prepared from precursors in a process known as Sol-Gel. Precursors of SiO₂ may be selected in the group of tetramethyl orthosilicate, tetraethyl orthosilicate, polydiethyoxysilane, n- alkyltrimethoxylsilanes such as for example 3- (2- (2- aminoethylamino)ethylamino)propyltrimethoxysilane, n- butyltrimethoxysilane, n- octyltrimethoxylsilane, n-dodecyltrimethoxysilane, n- octadecyltrimethoxysilane, 3-mercaptopropyltrimethoxysilane, 11- mercaptoundecyltrimethoxysilane, 3-aminopropyltrimethoxysilane, 11- aminoundecyltrimethoxysilane, 3-(trimethoxysilyl)propyl methacrylate, 3- (aminopropyl)trimethoxysilane, or a mixture thereof. Inorganic polymers, *i.e.* polymer not containing carbon, are also particularly suitable. Inorganic polymer may be selected in the group of polysilanes, polysiloxanes (or silicones), polythiazyles, polyaluminosilicates, polygermanes, polystannanes, polyborazylenes, polyphosphazenes, polydichlorophosphazenes, polysulfides, polysulfur and/or nitrides.

A preferred size for composite particles is between 50 nm and 250 nm.

According to one embodiment, black pigments may have different shapes selected among cubes, spheres, rods, wires, rings, plates, sheets, ribbons or disks.

According to one embodiment, black pigments are distributed uniformly on the silver-based substrate.

According to one embodiment, black pigments are distributed according to a predetermined pattern on the silver-based substrate. In this embodiment, metal sulfide and especially silver sulfide (Ag2S) particles are advantageous. Indeed, if silver-based substrate undergoes tarnishing uniformly, as one expects in reaction to pollution for instance - this uniform colour would not affect the contrast between the dark-coloured pattern and the shiny silver. Knowing that human eye is much more sensitive to contrast than to absolute coloration, the colour would again appear stable, as well as the shape of the pattern.

According to one embodiment, black pigments are deposited on the silver-based substrate according to a density of black pigments per surface unit greater than 10 mg.m⁻². The density of black pigments per surface unit on the substrate refers to the number of black pigments per volume unit of coating deposited on the substrate multiplied by the thickness of the layer of black pigments on said substrate.

A high density of black pigments is preferred also because the coating or the portion of coating comprising black pigments is more uniform, compact and without cracks.

### Continuous matrix

By continuous, it is meant that the matrix covers the whole surface of the substrate, without holes allowing a direct contact of silver-based substrate with atmosphere or skin for instance.

According to one embodiment, the continuous matrix (nitride and/or oxide) comprises a material having a band gap superior or equal to 3 eV. Advantageously, the continuous matrix does not absorb light in the visible range, *i.e.,* is transparent in the range of wavelengths where black pigments absorb light - typically from 380 nm to 780 nm.

According to one embodiment, the nitride continuous matrix comprises at least one of titanium nitride (TiN), titanium(II) nitride (Ti₂N), titanium carbo-nitride (TiCN), titanium-aluminum nitride (TiAIN), titanium-aluminum carbo-nitride (TiAlCN), chromium nitride (CrN), zirconium nitride (ZrN), aluminum nitride (AlN), silicon nitride (SiN), chromium-titanium nitride (CrTiN), aluminum-titanium nitride (AlTiN), aluminum-titanium-chromium nitride (AlTiCrN), tungsten nitride (WN).

In a preferred configuration of this embodiment, the nitride continuous matrix comprises aluminum nitride (AlN) or silicon nitride (SiN).

According to one embodiment, the oxide continuous matrix comprises at least one of titanium oxide (TiO₂), carbon-titanium dioxide, titanium-aluminum oxide (Al₂TiO₅), chromium oxide (CrO), zirconium oxide (ZrO₂), aluminum oxide (Al₂O₃), silicon oxide (SiO₂), chromium-titanium oxide (Cr₂TiO₅), aluminum-titanium oxide (Al₂O₅Ti), tungsten oxide (WO₃).

According to one embodiment, the oxinitride continuous matrix comprises at least one of aluminum oxynitride (Al_{2/3}OₓN₁₋ₓ), silicon oxynitride (Si_{1/2}OₓN₁₋ₓ), titanium oxynitride (Ti_{1/2}OₓN₁₋ₓ), titanium-aluminum oxinitride (TiAlOₓN₁₋ₓ), aluminum-chromium oxynitride ((Al,Cr)OₓN₁₋ₓ), aluminum-titanium-chromium oxynitride ((Al,Cr)TiOₓN₁₋ₓ), where x is a real number strictly comprised between 0 and 1.

### Adhesion layer

Optionally, the coating comprises an adhesion layer. This adhesion layer is between the silver-based substrate and the nitride and/or oxide continuous matrix comprising black pigments.

The adhesion layer may be selected from the nitride materials, the oxide materials and the oxynitride materials listed hereabove for the continuous matrix. Preferably, the adhesion layer is an oxide material.

The thickness of the adhesion layer is ranging from 1 nm to 25 nm, preferably from 1 nm to 10 nm.

Thanks to the adhesion layer, the black pigments adhere strongly to the substrate during deposition of the nitride and/or oxide continuous matrix, leading to a better control of dark coloration and/or pattern of the silver-based substrate.

### Coating

According to one embodiment, the weight fraction of black pigments in the coating is ranging from 1 %wt to 30 %wt, based on the total weight of the coating, preferably from 2 %wt to 20 %wt.

According to one embodiment, the absorbance of the coating where black pigments are present - along a pattern if applicable - is ranging from 0.1 to 2.

According to one embodiment, the lightness of the coated silver-based substrate (in the CIE L^{∗}a^{∗}b^{∗} color space - also known as L^{∗}a^{∗}b^{∗} - defined by the International Commission on Illumination (CIE) in 1976) is lower by 10 unit or more than the lightness of the un-coated silver-based substrate (before coating, or outside a deposited black pattern).

According to one embodiment, the thickness of the coating is ranging from 10 nm to 1000 nm, preferably from 20 nm to 700 nm, to minimize a change in optical appearance of areas of the silver-based substrate where black pigments are not present.

According to one embodiment, the coated silver-based substrate has one or more of:
- a scratch resistance (ISO 1508) showing no fracturing of the coating at visual inspection,
- a resistance to corrosion by sweat (test carried out by exposure to synthetic sweat, ISO 3160-2), showing good result after visual inspection (immersing the sample in the artificial sweat maintained at 37° C±2° C. for a week, and the state of the surface was observed to examine the degree of corrosion. The surface that was not corroded was regarded to be good and the surface that was corroded a little was regarded to be not good),
- a resistance to corrosion by sulphureous agents (test carried out by exposure to thioacetamide, NF EN ISO 4538) with a ΔE(L^{∗},a^{∗},b^{∗}) lower than 5 after 150 hours exposure to thioacetamide,
- a good resistance to polyservice type wear (standard ISO 16253 or ISO 23160, measured with a Turbula T2C device).

Thus, the coating disclosed herein advantageously protects the silver-based substrate from tarnishing, oxidation, sulfidation as well as deep attack and the effects of infiltration of aggressive agents to its surface. Indeed, it is required that silver-based jewelry do not suffer any deterioration while being worn or stored.

This invention also relates to a silver-based substrate with a coating in contact with the substrate,
wherein the coating comprises a nitride and/or oxide continuous matrix,
wherein the coating thickness is ranging from 10 nm to 1000 nm,
wherein the silver-based substrate and the coating at least partially form a jewelry article or a component of a jewelry article,
wherein the coated silver-based substrate has one or more of:

- a scratch resistance (ISO 1508) showing no fracturing of the coating at visual inspection,
- a resistance to corrosion by sweat (test carried out by exposure to synthetic sweat, ISO 3160-2), showing good result after visual inspection (immersing the sample in the artificial sweat maintained at 37° C±2° C. for a week, and the state of the surface was observed to examine the degree of corrosion. The surface that was not corroded was regarded to be good and the surface that was corroded a little was regarded to be not good),
- a resistance to corrosion by sulphureous agents (test carried out by exposure to thioacetamide, NF EN ISO 4538) with a ΔE(L^{∗},a^{∗},b^{∗}) lower than 5 after 150 hours exposure to thioacetamide,
- a good resistance to polyservice type wear (standard ISO 16253 or ISO 23160, measured with a Turbula T2C device).

### Coating method

The invention also relates to a coating method comprising the steps of:
a) depositing black pigments on a silver-based substrate,
b) depositing a nitride and/or oxide layer on the black pigments and silver-based substrate,
wherein the silver-based substrate and the coating at least partially form a jewelry article or a component of a jewelry article.

Black pigments, silver-based substrates, jewelry articles are as described hereabove.

The nitride and/or oxide layer is obtained by depositing the nitride and/or oxide continuous matrix as described hereabove on the black pigments and silver-based substrate.

According to one embodiment, black pigments are deposited uniformly on the silver-based substrate.

According to one embodiment, black pigments are deposited on the silver-based substrate by powder printing, by stamping or with a stencil. Deposition may be a dry process, *i.e.,* black pigments are deposited without carrying medium. Alternatively, deposition may be a wet process. In wet processes, black pigments are first dispersed in a medium - preferably a liquid medium, water or organic solvent - and suspension obtained is deposited by dip coating, spray coating, spin coating, stamping, electrochemical coating, electroless coating for instance, then dried. Deposition of the suspension may be performed under the influence of an ultrasonic stimulation.

According to one embodiment, the nitride and/or oxide layer is deposited by physical vapor deposition (PVD), chemical vapor deposition (CVD), plasma enhanced chemical vapor deposition (PACVD), atomic layer deposition (ALD), ion assisted deposition (IAD), dip coating, spray coating, or spin coating.

According to one embodiment, an adhesion layer is deposited on the silver-based substrate before deposition of black pigments in a preparation step. The adhesion layer is preferably deposited by physical vapor deposition (PVD), chemical vapor deposition (CVD), plasma enhanced chemical vapor deposition (PACVD), atomic layer deposition (ALD), ion assisted deposition (IAD).

According to one embodiment, the method of the invention comprises a preliminary step of cleaning the silver-based substrate and/or removing substantially all pre-existing tarnish from the silver-based substrate.

In a specific configuration of this embodiment, cleaning is performed by subjecting the silver-based substrate to a solvent based ultrasonic cleaning process to ensure that its surface is free of organic residues or contamination.

In a specific configuration of this embodiment, pre-existing tarnish removal is performed by using a chemical tarnish remover configured to reverse the silver sulfide reaction, *i.e.,* it uses a chemical reaction to convert the silver sulfide back to silver.

Advantageously, the preliminary step and/or the preparation step improves the adhesion of black pigments and nitride and/or oxide layer on the silver-based substrate.

### BRIEF DESCRIPTION OF THE DRAWINGS

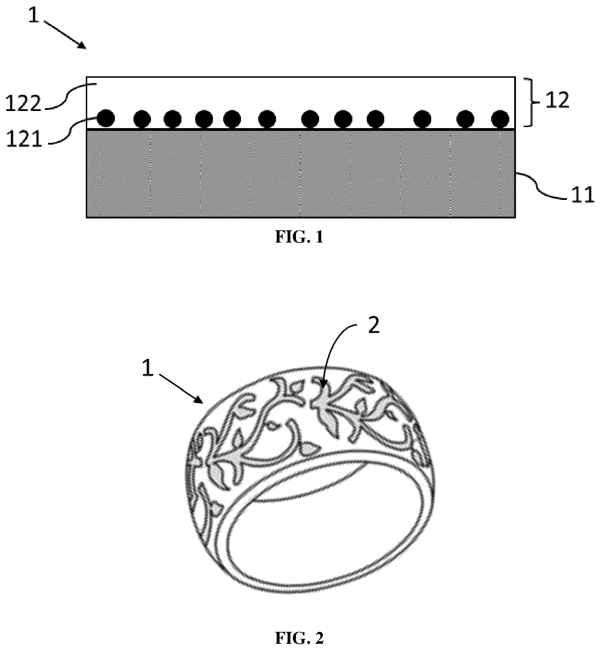

**Figure 1** is a schematic side view of a silver-based substrate 11 covered with a coating 12 comprising a composite layer of black pigments 121 embedded in a nitride continuous matrix 122.
In a first embodiment, illustrated on Figure 1, the silver-based substrate 11 is covered with a coating 12 in contact with the substrate, the coating 12 comprising a composite layer of black pigments 121 embedded in a nitride continuous matrix 122.
The silver-based substrate 11 and the coating 12 at least partially form a jewelry article 1 or a component of a jewelry article.
**Figure 2** is a view of a silver-based ring 1 with a black pattern 2 - here a plant-inspired pattern.

### EXAMPLES

The present invention is further illustrated by the following examples.

### Example 1-1: Uniform deposition of black pigments on a silver substrate

All pre-existing tarnish is removed from a silver substrate using a chemical tarnish remover. The silver substrate is then cleaned in a solvent based ultrasonic bath to ensure that the surface is free of organic residues or contamination.

A suspension of black pigments comprising Ag2S nanoparticles (5 nm diameter) in ethanol at a concentration of 5% in weight is prepared.

Black pigments are dispersed uniformly over the silver substrate by spray coating.

The silver substrate supporting black pigments is rinsed with a solvent to prevent the formation of large agglomerates and dried, leaving a coating of about 10 nm - about two layers of nanoparticles or 10 mg.m⁻².

Next, a layer of aluminum nitride is deposited using IAD (ion assisted deposition) to obtain a thickness of 50 nm.

Example was reproduced with deposition of 50 nm of aluminum nitride by ALD (atomic layer deposition).

The silver substrate shows a uniform dark colour, and pass the scratch resistance test, the sweat corrosion test, the sulphureous agents corrosion test and the polyservice wear test.

### Example 1-2: Uniform deposition of black pigments on a silver substrate

Example 1 was reproduced using PbS nanoparticles (7 nm diameter), yielding a similar result and passing all resistance tests.

### Example 1-3: Uniform deposition of black pigments on a silver substrate

Example 1 was reproduced using HgTe nanoparticles (6 nm diameter), yielding a similar result and passing all resistance tests.

### Example 2: Deposition of black pigments on a silver substrate according to a pattern

All pre-existing tarnish is removed from a silver ring using a chemical tarnish remover. The silver substrate is then cleaned in a solvent based ultrasonic bath to ensure that the surface is free of organic residues or contamination.

A suspension of black pigments comprising Ag2S nanoparticles (5 nm diameter) in ethanol at a concentration of 5% in weight is prepared.

Black pigments are dispersed according to a predetermined pattern over the silver substrate using a stencil supporting said pattern, as shown on Figure 2.

The silver substrate supporting black pigments is rinsed with a solvent to prevent the formation of large agglomerates and dried, leaving a coating of about 10 nm - about two layers of nanoparticles or 10 mg.m⁻².

Next, a layer of aluminum nitride is deposited using IAD (ion assisted deposition) to obtain a thickness of 60 nm.

Example was reproduced with deposition of 60 nm of aluminum nitride by ALD (atomic layer deposition).

The silver substrate shows a well definite dark colour pattern, and pass the scratch resistance test, the sweat corrosion test, the sulphureous agents corrosion test and the polyservice wear test.

## Claims

1. A silver-based substrate with a coating in contact with the substrate,
wherein the coating comprises a composite layer of black pigments embedded in a nitride and/or oxide continuous matrix, and
wherein the silver-based substrate and the coating at least partially form a jewelry article or a component of a jewelry article.

2. The silver-based substrate according to claim **1,** wherein black pigments are selected in the group of carbon black, ivory black, vine black, lamp black, graphene, mars black, iron black, manganese dioxide, titanium black, semi-conductive nanoparticles having a band gap of 1.6 eV or less.

3. The silver-based substrate according to claim **2,** wherein the semi-conductive nanoparticles having a band gap of 1.6 eV or less are metal chalcogenides, where metal is selected from Hg, Pb, Ag, Bi, Cd, Sn, Sb or a mixture thereof and chalcogen is selected from S, Se, Te or a mixture thereof, preferably semi-conductive nanoparticles having a band gap of 1.6 eV or less are selected from HgS, HgSe, HgTe, HgSeS, HgSeTe, HgₓCd₁₋ₓTe wherein x is a real number strictly comprised between 0 and 1, PbS, PbSe, PbTe, Bi₂S₃, Bi₂Se₃, Bi₂Te₃, SnS, SnS₂, SnTe, SnSe, Sb2S3, Sb2Se3, Sb2Te3, Ag2S, Ag2Se, Ag2Te and mixtures thereof.

4. The silver-based substrate according to any one of claims **1** to **3,** wherein the nitride and/or oxide continuous matrix comprises at least one of titanium nitride (TiN), titanium(II) nitride (Ti2N), titanium carbo-nitride (TiCN), titanium-aluminum nitride (TiAIN), titanium-aluminum carbo-nitride (TiAlCN), chromium nitride (CrN), zirconium nitride (ZrN), aluminum nitride (AlN), silicon nitride (SiN), chromium-titanium nitride (CrTiN), aluminum-titanium nitride (AlTiN), aluminum-titanium-chromium nitride (AlTiCrN), tungsten nitride (WN), titanium oxide (TiO₂), carbon-titanium dioxide, titanium-aluminum oxide (Al₂TiO₅), chromium oxide (CrO), zirconium oxide (ZrO₂), aluminum oxide (Al₂O₃), silicon oxide (SiO₂), chromium-titanium oxide (Cr₂TiO₅), aluminum-titanium oxide (Al₂O₅Ti), tungsten oxide (WO₃), aluminum oxynitride (Al_{2/3}OₓN₁₋ₓ), silicon oxynitride (Si_{1/2}OₓN₁₋ₓ), titanium oxynitride (Ti_{1/2}OₓN₁₋ₓ), titanium-aluminum oxinitride (TiAlOₓN₁₋ₓ), aluminum-chromium oxynitride ((Al,Cr)OₓN₁₋ₓ), aluminum-titanium-chromium oxynitride ((Al,Cr)TiOₓN₁₋ₓ), where x is a real number strictly comprised between 0 and 1.

5. The silver-based substrate according to any one of claims **1** to **4,** wherein black pigments are distributed uniformly on the silver-based substrate.

6. The silver-based substrate according to any one of claims **1** to **4,** wherein black pigments are distributed according to a predetermined pattern on the silver-based substrate.

7. The silver-based substrate according to any one of claims **1** to **6,** wherein the weight fraction of black pigments in the coating is ranging from 1 %wt to 30 %wt.

8. The silver-based substrate according to any one of claims **1** to **7,** wherein the absorbance of the coating is ranging from 0.1 to 2, where black pigments are present.

9. The silver-based substrate according to any one of claims **1** to **8,** wherein the thickness of the coating is ranging from 10 nm to 1000 nm.

10. A coating method comprising the steps of
a) depositing black pigments on a silver-based substrate,
b) depositing a nitride and/or oxide layer on the black pigments and silver-based substrate,
wherein the silver-based substrate and the coating at least partially form a jewelry article or a component of a jewelry article.

11. A coating method according to claim **10,** wherein black pigments are deposited uniformly on the silver-based substrate.

12. A coating method according to claim **10,** wherein black pigments are deposited on the silver-based substrate according to a predetermined pattern, for instance by stamping or with a stencil.

13. A coating method according to any one of claims **10** to **12,** wherein the nitride and/or oxide layer is deposited by PVD, CVD, PACVD, ALD, IAD, dip coating, spray coating, spin coating.

14. A coating method according to any one of claims **10** to **13,** wherein the black pigments are selected in the group of carbon black, ivory black, vine black, lamp black, graphene, mars black, iron black, manganese dioxide, titanium black, semi-conductive nanoparticles having a band gap of 1.6 eV or less.

15. A coating method according to any one of claims **10** to **14,** wherein the nitride continuous matrix comprises at least one of titanium nitride (TiN), titanium(II) nitride (Ti2N), titanium carbo-nitride (TiCN), titanium-aluminum nitride (TiAIN), titanium-aluminum carbo-nitride (TiAlCN), chromium nitride (CrN), zirconium nitride (ZrN), aluminum nitride (AlN), silicon nitride (SiN), chromium-titanium nitride (CrTiN), aluminum-titanium nitride (AlTiN), aluminum-titanium-chromium nitride (AlTiCrN), tungsten nitride (WN), ), titanium oxide (TiO₂), carbon-titanium dioxide, titanium-aluminum oxide (Al₂TiO₅), chromium oxide (CrO), zirconium oxide (ZrO₂), aluminum oxide (Al₂O₃), silicon oxide (SiO₂), chromium-titanium oxide (Cr₂TiO₅), aluminum-titanium oxide (Al₂O₅Ti), tungsten oxide (WO₃), aluminum oxynitride (Al_{2/3}OₓN₁₋ₓ), silicon oxynitride (Si_{1/2}OₓN₁₋ₓ), titanium oxynitride (Ti_{1/2}OₓN₁₋ₓ), titanium-aluminum oxinitride (TiAlOₓN₁₋ₓ), aluminum-chromium oxynitride ((Al,Cr)OₓN₁₋ₓ), aluminum-titanium-chromium oxynitride ((Al,Cr)TiOₓN₁₋ₓ), where x is a real number strictly comprised between 0 and 1.
